Europäisches Patentamt

European Patent Office

Office européen des brevets

(19)

(11) Numéro de publication: **0 334 733**
**A1**

# DEMANDE DE BREVET EUROPEEN

(21) Numéro de dépôt: 89400757.4

(22) Date de dépôt: 17.03.89

(51) Int. Cl.⁴: **G 06 K 19/06**

(30) Priorité: 22.03.88 FR 8803695

(43) Date de publication de la demande:
27.09.89 Bulletin 89/39

(84) Etats contractants désignés:
BE CH DE ES GB IT LI LU NL SE

(71) Demandeur: **SCHLUMBERGER INDUSTRIES**
**50, avenue Jean Jaurès**
**F-92120 Montrouge (FR)**

(72) Inventeur: **Audic, Bernard**
**39, rue Lily**
**F-92140 Clamart (FR)**

**Bugeia, Christian**
**66, rue Colombes**
**F-41000-Blois (FR)**

(74) Mandataire: **Dronne, Guy**
**SCHLUMBERGER INDUSTRIES 50, avenue Jean Jaurès**
**F-92120 Montrouge (FR)**

(54) Procédé de réalisation d'une carte à mémoire électronique et carte telle qu'obtenue par la mise en oeuvre dudit procédé.

(57) L'invention concerne un procédé de réalisation de carte à mémoire électronique.

Pour fixer le module électronique (14) dans la cavité (12, 14, 16) du corps de carte (10) on place sur l'épaulement (18) de la cavité une couronne (20) de fixation. La couronne (20) consiste en une structure fibreuse imprégnée d'un matériau adhésif thermo-activable. On exerce une certaine pression sur le module électronique (14) en écrasant la couronne (20) pour positionner le module. On apporte de l'énergie thermique à l'élément de fixation pour provoquer l'activation et le polymérisation du matériau adhésif qu'il contient.

FIG.3

EP 0 334 733 A1

## Description

## PROCEDE DE REALISATION D'UNE CARTE A MEMOIRE ELECTRONIQUE ET CARTE TELLE QU'OBTENUE PAR LA MISE EN OEUVRE DUDIT PROCEDE

La présente invention a pour objet un procédé de réalisation d'une carte à mémoire électronique et une carte telle qu'obtenue par la mise en oeuvre dudit procédé.

Une carte à mémoire électronique se compose essentiellement d'un corps de carte de forme générale parallélépipèdique rectangle et d'un module électronique fixé dans le corps de carte. Le corps de carte, qui est réalisé en un matériau thermoplastique tel que du polyvinylchlorure (PVC), présente deux faces principales sensiblement parallèles entre elles. Le module électronique, quant à lui, comporte le plus souvent un support isolant sur une face duquel sont réalisées les plages de contact externes de la carte, et une pastille semi-conductrice fixée sur l'autre face du support isolant et reliée électriquement aux plages de contact externes.

Il existe plusieurs types de procédés pour fixer le module électronique dans le corps de carte. Un de ces procédés consiste à réaliser une cavité dans le corps de la carte, à placer le module électronique dans la cavité, et à le coller de telle manière que les plages de contact externe du module électronique soient sensiblement dans le plan de la face principale du corps de carte.

Le collage du module électronique sur le corps de carte est un problème délicat. En effet, d'une part, le collage doit être efficace pour que la carte satisfasse aux tests de flexion imposés, d'autre part le collage ne doit pas entraîner des opérations susceptibles d'augmenter sensiblement le coût de fabrication de la carte.

En outre, lors de l'opération de collage, il est très souhaitable de pouvoir rattraper les dispersions sur les cotes de la cavité du corps de carte et du module électronique, afin que, après le collage, les plages de contact externe soient effectivement dans le plan de la face principale du corps de carte.

La demande de brevet européen n° 201.952 déposée au nom de RTC Compelec décrit un procédé de collage qui consiste à utiliser un matériau auto-adhésif double face.

Un tel procédé est d'une mise en oeuvre délicate en raison du caractère auto adhésif double face du matériau de collage. En outre il ne permet pas de rattraper les dispersions dans le sens de l'épaisseur, sur les cotes du module électronique et de la cavité.

Un objet de la présente invention est de fournir un procédé de réalisation d'une carte à mémoire électronique qui permette la fixation du module électronique sur le corps de carte à l'aide d'opérations plus simples que celles des procédés de l'art antérieur.

Pour atteindre ce but le procédé de réalisation d'une carte à mémoire comportant un corps de carte présentant une face principale, et un module électronique comprenant un support ayant sur une de ses faces des plages externes de contact électrique et sur son autre face une pastille semi-conductrice, se caractérise en ce qu'il comprend les étapes suivantes :

On fournit un corps de carte présentant une cavité débouchant dans une face principale du corps de carte;

On place dans une partie de la cavité un élément de fixation présentant deux faces en un matériau adhésif thermo activable;

On place ledit module électronique dans ladite cavité de telle manière qu'une face dudit élément de fixation soit en contact avec une partie dudit support ; et

On soumet ledit élément de fixation à un apport d'énergie pour réaliser le collage d'une face de l'élément de fixation sur ledit support et de l'autre face dudit élément sur ledit corps de carte.

Un autre objet de l'invention est de fournir un procédé de réalisation d'une carte à mémoire électronique qui permette le positonnement précis du module électronique dans la direction de l'épaisseur du corps de carte.

Pour atteindre ce but, de préférence, ledit procédé se caractérise en outre en ce que ledit élément de fixation a une épaisseur qui peut être modifiée sous l'effet d'une pression, et en ce que, tout en apportant ladite énergie on applique sur une partie dudit module une pression pour modifier l'épaisseur dudit élément de fixation jusqu'à ce que lesdites plages de contact soient sensiblement dans le plan de la face principale dudit corps, et on maintient ladite pression jusqu'à ce que ledit élément de fixation assure un collage irréversible en conservant audit élément de fixation ladite épaisseur modifiée.

Encore un autre objet de l'invention est de fournir une carte à mémoire électronique telle qu'obtenue par la mise en oeuvre du procédé de fabrication selon l'invention.

De toutes façons l'invention sera mieux comprise à la lecture de la description qui suit de plusieurs modes de réalisation de l'invention donnés à titre d'exemples non limitatifs. La description se réfère au dessin annexé sur lequel :

La figure 1 montre en coupe verticale une partie d'un corps de carte avec l'élément de fixation mis en place ;

La figure 2 est une demi-vue de dessus du corps de carte représenté sur la figure 1 ;

Les figures 3 et 4 montrent la mise en place et la fixation du module électronique dans le corps de carte des figures 1 et 2 ;

La figure 5 montre en vue de dessus une variante de réalisation de la cavité dans le corps de la carte ; et la figure 6 est une vue du corps de carte en coupe selon la ligne VI-VI de la figure 5.

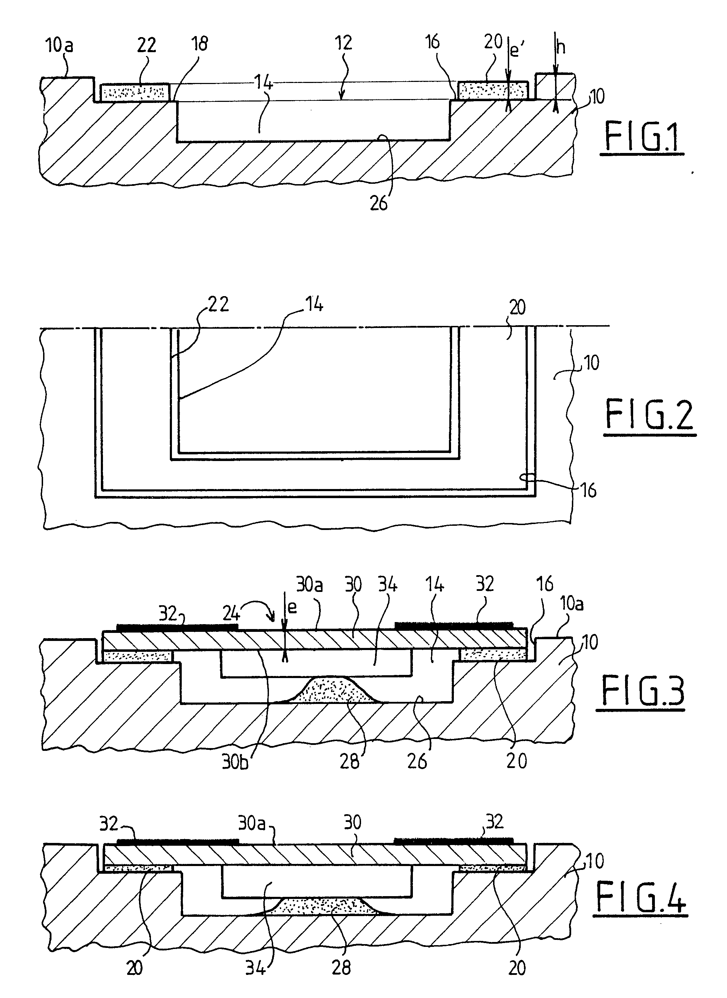

En se référant tout d'abord aux figures 1 à 4 on va décrire un premier mode de réalisation d'une carte à mémoire électronique selon l'invention.

On part d'un corps de carte 10 qui présente une cavité 12. La cavité est étagée c'est à dire qu'elle est constituée par un logement inférieur 14 et par un logement supérieur 16 de plus grandes dimensions. La cavité 12 comporte ainsi un épaulement 18 qui entoure la cavité inférieure 14.

Dans une première étape on dépose sur l'épaulement 18 un élément de fixation 20 qui a la forme d'une "couronne". L'élément a sensiblement, en plan, la forme de l'épaulement 18 c'est à dire qu'il comporte un évidement central 22 qui a, en plan, la forme du logement 14. L'élément de fixation 20 est découpé dans un matériau thermo-adhésif constitué par une structure fibreuse imprégnée d'un produit adhésif thermo-activable. A la température ambiante l'élément de fixation 20 n'est donc pas "collant" et peut être manipulé sans précaution particulière. Il s'agit par exemple du matériau ABLE film 561 commercialisé par la Société ABLE. C'est un matériau en feuille ou en bande dont l'épaisseur est de l'ordre de 0,1 mm. Il est formé par une structure en fibres de verre imprégnée d'une résine époxy. La structure tissée ou non tissée constitue une trame qui peut légèrement s'écraser pour compenser les différentes décotes. Cependant grâce à la structure l'écrasement est uniforme sur toute sa surface.

Dans l'étape suivante, représentée sur la figure 3, on met en place un module électronique 24 dans la cavité 12. Au préalable on dépose sur le fond 26 de la cavité 12 une goutte 28 d'un matériau adhésif. Le module électronique 24 peut avoir des structures variables correspondant à différentes technologies maintenant bien connues.

Dans tous les cas, le module 24 comprend un support isolant 30. Sur une face 30a du support 30 sont réalisées des plages externes de contact électrique 32. Une pastille semi-conductrice 34 est fixée sur l'autre face 30b du support isolant. Les demandes de brevet français 83/18993, 85/04658 et 86/14231 décrivent de tels modules.

Des connexions électriques, non représentées sur la figure 3, permettent de relier électriquement les bornes de la pastille 34 aux plages de contact 32. La pastille 34 et les fils de connexion sont enrobés dans un matériau de protection qui peut être moulé pour lui donner une forme extérieure convenable. En plan, le support isolant 30 du module électronique 24 a des dimensions très légèrement inférieures aux dimensions correspondantes du logement supérieur 16. En plan, le support isolant 30 pénètre donc entièrement dans le logement 16. La périphérie du support isolant 30 repose sur la face supérieure de l'élément de fixation 20. L'épaisseur $e$ du support isolant 30 est inférieure à la profondeur $h$ du logement 16. L'épaisseur $e'$ de l'élément de fixation 20 est également inférieure à la profondeur $h$ du logement 16. En revanche la profondeur $h$ est inférieure à la somme des épaisseurs $e$ et $e'$. En conséquence, comme le montre la figure 3, la face 30a du support isolant fait saillie hors de la face supérieure 10a du corps de carte 10. En outre la goutte d'adhésif 28 n'occupe qu'une faible partie de la portion de la cavité 12 non occupée par le module 24. Il est important de s'assurer que le matériau d'enrobage du module électronique ne déborde sur la périphérie du support isolant 30 qui doit être en contact avec l'élément de fixation 20. Il est donc intéressant de réaliser cet enrobage par moulage ce qui permet d'en définir avec précision la forme externe. Une première technique consiste à utiliser un moulage par injection de matériau thermoplastique. Une seconde technique consiste à réaliser le moulage par "transfert". Dans une première phase de la poudre du matériau d'enrobage (par exemple une résine epoxy) est chauffée pour passer à l'état fluide. Ce fluide est introduit dans la cavité du moule qui définit la forme externe de l'enrobage, et on provoque sa polymérisation.

Dans l'étape suivante illustrée par la figure 4, on exerce sur la face supérieure 30a du module une pression pour écraser l'élément de fixation 20 jusqu'à ce que la face supérieure 30a du module soit sensiblement dans le plan de la face supérieure 10a du corps de carte 10. Cet écrasement est rendu possible par l'écrasement de la structure fibreuse de l'élément de fixation 20. Simultanément on chauffe localement le module électronique 14 pour activer le matériau adhésif de l'élément de fixation 20 et éventuellement la goutte de résine 28. Lorsque le matériau adhésif est suffisamment polymérisé on peut supprimer la pression sur le module. Il faut maintenir une température de l'ordre de 120 à 150° pendant 3 à 4 secondes environ. En effet après la polymérisation et le durcissement du matériau adhésif de l'élément de fixation, non seulement la périphérie du support isolant 30 est collée efficacement sur le corps de carte 10, mais encore le durcissement de ce matériau maintien l'écrasement voulu de la structure fibreuse de l'élément de fixation 20 de telle sorte que la cote de la face supérieure 30a du support isolant est maintenue. L'apport d'énergie peut être réalisé par tout moyen convenable : outil de pressage à chaud, ultra-sons, infra-rouge ; air chaud pulsé etc...

On comprend que par cette technique on obtient non seulement la fixation du module électronique sur le corps de carte par la mise en oeuvre d'étapes plus simples que dans le cas d'un matériau auto-adhésif, mais encore on réalise un positionnement précis et simple des plages de contact 32 par rapport à la face supérieure 10a du corps de carte. De plus le matériau adhésif de l'élément de fixation 20 étant emprisonné dans la structure fibreuse il ne peut s'écouler à l'extérieur lors de la compression.

Lors du chauffage on obtient également éventuellement la polymérisation de la goutte de résine 28. Comme le montre la figure 4, la goutte 28 assure donc la solidarisation entre le corps de carte et la face du module électronique non fixée sur le support isolant 30. Il faut observer que la goutte de résine epoxy 28 peut avoir un volume réduit puisqu'elle a seulement pour but d'assurer la liaison entre le module électronique et le fond 26 de la cavité 12. Elle n'a pas besoin de remplir la cavité 12. Il en résulte que même si la définition du volume de la goutte d'epoxy n'est pas très précise, la résine epoxy ne risque pas de déborder hors de la cavité 12 lors de la mise en place du module électronique 14. Dans le cas où l'enrobage du module électronique a été réalisé par moulage sa forme extérieure est parfaitement contrôlée. Le volume restant libre dans la cavité 12 est donc aussi bien défini. Cela facilite le contrôle de la quantité de colle devant former la goutte 28.

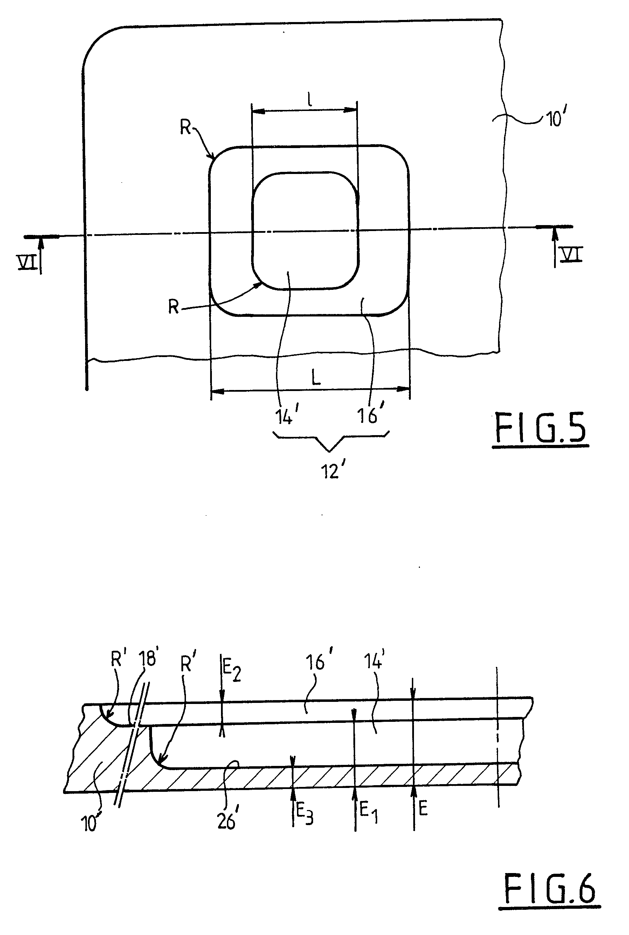

Les figures 5 et 6 montrent une variante de réalisation de la cavité 12 ménagée dans le corps 10 de la carte. Sur ces figures on a repris les mêmes références que sur les figures 1 à 4, mais en les affectant du signe "prime".

La différence avec le mode de réalisation des figures 1 à 4 réside uniquement dans le fait que les différentes parties de la cavité 12', c'est à dire les logements 14' et 16', sont limitées par des surfaces raccordées entre elles par des congés, au lieu de se raccorder à angle droit.

La figure 5 montre que les parois verticales, c'est à dire disposées selon l'épaisseur du corps de carte, respectivement des logements 14' et 16', sont raccordées par des congés présentant un rayon de courbure R de l'ordre de 1,75 mm. A titre de comparaison les dimensions l et L de la cavité 12' sont respectivement égales à 7,5 mm et 13,2 mm.

De même les raccordements entre le fond 26' de la cavité 12' et les parois "verticales" du logement 14' ainsi que le raccordement entre l'épaulement 18' et les parois "verticales" du logement 16' sont réalisés par des congés dont le rayon de courbure R' est de l'ordre de 0,2 mm. A titre de comparaison l'épaisseur du corps de carte E est de 0,8mm, la profondeur $E_1$ du logement 14' est de 0,38mm et la profondeur $E_2$ du logement 16' est de 0,2mm.

Ces congés permettent de réduire les contraintes locales au niveau des raccordements entre les surfaces limitant la cavité 12'. Les congés de raccordement au fond 26' permettent en outre d'accroître la résistance mécanique en flexion de la portion du corps de carte séparant le fond de la cavité 26' de la face arrière 10'b du corps de carte. Cette dernière disposition est particulièrement intéressante puisque cette partie du corps de carte a une épaisseur réduite $E_3$ de 0,22 mm.

Il faut de plus observer que le matériau adhésif 28 qui relie le fond 26' de la cavité au module électronique 14 améliore la résistance mécanique de cette partie du corps de carte et constitue un isolant thermique entre le circuit intégré formé dans la pastille semi-conductrice son enrobage et le corps de carte pour éviter la déformation de la face arrière du corps de carte. On a donc intérêt à choisir un matériau adhésif qui soit un bon isolant thermique.

## Revendications

1. Procédé de réalisation d'une carte à mémoire comportant un corps de carte présentant une face principale, et un module électronique comprenant un support ayant sur une de ses faces des plages externes de contact électrique et sur son autre face une pastille semi-conductrice, caractérisé en ce qu'il comprend les étapes suivantes :
On fournit un corps de carte présentant une cavité débouchant dans une face principale du corps de carte;
On place dans une partie de la cavité un élément de fixation présentant deux faces en un matériau adhésif thermo activable;
On place ledit module électronique dans ladite cavité de telle manière qu'une face dudit élément de fixation soit en contact avec une partie dudit support ; et
On soumet ledit élément de fixation à un apport d'énergie pour réaliser le collage d'une face de l'élément de fixation sur ledit support et de l'autre face dudit élément sur ledit corps de carte.

2. Procédé selon la revendication 1, caractérisé en ce que ledit élément de fixation a une épaisseur qui peut être modifiée sous l'effet d'une pression, et en ce que tout en apportant ladite énergie on applique sur une partie dudit module une pression pour modifier l'épaisseur dudit élément de fixation jusqu'à ce que lesdites plages de contact soient sensiblement dans le plan de la face principale dudit coprs, et on maintient ladite pression jusqu'à ce que ledit élément de fixation assure une collage irréversible en conservant audit élément de fixation ladite épaisseur modifiée.

3. Procédé selon la revendication 2, caractérisé en ce que ledit élément de fixation a la forme d'une couronne pour entourer ladite pastille semi-conductrice et en ce qu'il est constitué par une structure écrasable dans laquelle est retenu ledit matériau adhésif thermo-activable.

4. Procédé selon la revendication 3 caractérisé en ce que ladite structure constitue une trame dont l'écrasement est sensiblement uniforme sur toute la surface dudit élément de fixation.

5. Procédé selon l'une quelconque des revendications 1 à 7, caractérisé en ce qu'il comprend en outre comme étape de déposer au fond de ladite cavité une goutte d'un matériau adhésif avant de mettre en place ledit module électronique dans ladite cavité et d'activer ledit matériau adhésif pour réaliser une liaison entre le fond de ladite cavité et ledit module électronique.

6. Procédé selon l'une quelconque des revendications 1 à 7, caractérisé en ce que ladite cavité comporte un premier logement muni d'un fond pour recevoir ladite pastille semi-conductrice du module et un deuxième logement débouchant dans une face principale dudit corps pour recevoir ledit support du module et raccordé audit premier logement par un épaulement, ledit élément de fixation étant disposé sur ledit épaulement.

7. Carte à mémoire électronique comprenant un corps de carte présentant une face principale et, muni d'une cavité, et un module électronique disposé dans ladite cavité, ledit module électronique comprenant un support dont une face est sensiblement disposées dans le plan de ladite face principale et une pastille semi-conductrice fixé sur l'autre face dudit support, caractérisé en ce que ledit module électronique est fixé sur ledit corps de carte par un élément de fixation en partie constitué par un matériau adhésif thermo-activable, ledit élément de fixation étant disposé entre ledit support du module électronique et une partie de ladite cavité.

8. Carte à mémoire électronique selon la revendication 7, caractérisée en ce qu'elle comprend en outre un moyen de liaison entre ledit module électronique et le fond de ladite cavité, ledit moyen de liaison comprenant un matériau liquide ou pateux au moment de l'insertion et durcissant ultérieurement..

9. Carte à mémoire électronique selon la revendication 8, caractérisée en ce que ledit matériau est un isolant thermique.

10. Carte à mémoire électronique selon l'une quelconque des revendications 7 à 9, caractérisée en ce que ladite cavité comprend un premier logement muni d'un fond pour recevoir ladite pastille semi conductrice et un deuxième logement débouchant dans une face principale dudit corps pour recevoir ledit support du module et raccordé audit logement par un épaulement, et en ce que ledit élément de fixation est disposé sur ledit épaulement.

11. Carte à mémoire électronique selon la revendication 10, caractérisé en ce que ledit fond de la cavité est raccordé à la paroi latérale dudit premier logement par un premier congé et en ce que ledit épaulement est raccordé à la paroi latérale dudit deuxième logement par un deuxième congé.

FIG.1

FIG.2

FIG.3

FIG.4

FIG.5

FIG.6

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| Y,D | EP-A-0 197 847 (FLONIC)<br>* Figures 1,6-12; page 13, ligne 1 - page 16, ligne 23 *<br>--- | 1,2,5,-10 | G 06 K 19/06 |
| Y | EP-A-0 140 230 (GAO GESELLSCHAFT FÜR AUTOMATION UND ORGANISATION mbH)<br>* Figures 5-7,12-13; page 8, ligne 37 - page 9, ligne 34; page 13, lignes 13-29; page 14, lignes 15-30 *<br>--- | 1,2,5-10 | |
| A,D | EP-A-0 201 952 (R.T.C. COMPELEC)<br>* Figure 3; colonne 6, lignes 8-26 *<br>--- | 1,7 | |
| A | EP-A-0 139 924 (INTERNATIONAL BUSINESS MACHINES CORP.)<br>* Figure 1; page 8, ligne 19 - page 9, ligne 5 *<br>--- | 1,7 | |
| P,X | US-A-4 804 828 (Y. OOGITA)<br>* Figures 1-3; colonne 1, lignes 25-33; colonne 2, lignes 7-41 *<br>----- | 1,6,7,10 | DOMAINES TECHNIQUES RECHERCHES (Int. Cl.4)<br><br>G 06 K<br>H 01 L |

Le présent rapport a été établi pour toutes les revendications

| Lieu de la recherche | Date d'achèvement de la recherche | Examinateur |
|---|---|---|
| LA HAYE | 23-06-1989 | GYSEN L.A.D. |